Europäisches Patentamt

European Patent Office

Office européen des brevets

(19)

(11) Veröffentlichungsnummer: **0 193 211 B1**

(12) **EUROPÄISCHE PATENTSCHRIFT**

(45) Veröffentlichungstag der Patentschrift: **27.03.91**

(51) Int. Cl.5: **H03K 3/295**, H03K 17/30

(21) Anmeldenummer: **86102680.5**

(22) Anmeldetag: **01.03.86**

(54) Schaltung zur Abgabe von Zündimpulsen.

(30) Priorität: **01.03.85 DE 8506354 U**

(43) Veröffentlichungstag der Anmeldung:
**03.09.86 Patentblatt 86/36**

(45) Bekanntmachung des Hinweises auf die
Patenterteilung:
**27.03.91 Patentblatt 91/13**

(84) Benannte Vertragsstaaten:
**AT BE CH DE FR GB IT LI LU NL SE**

(56) Entgegenhaltungen:
DE-A- 2 334 156          DE-A- 2 613 056
DE-B- 1 299 715          DE-B- 2 111 695
DE-B- 2 330 969          DE-B- 2 405 545

M. Kubat: "Power Semiconductors", Springer Verlag, Berlin Heidelberg New York Tokyo 1984, Seiten 435-436

(73) Patentinhaber: **Joh. Vaillant GmbH u. Co.
Berghauser Strasse 40 Postfach 10 10 20
W-5630 Remscheid 1(DE)DE IT LU SE**

Patentinhaber: **n.v. Vaillant s.a.
rue Golden Hopestraat 15
B-1620 Drogenbos(BE)BE**

Patentinhaber: **VAILLANT S.A.R.L
4, Rue des Oliviers Orly-Sénia 326
F-94537 Rungis Cedex(FR)FR**

Patentinhaber: **VAILLANT Ges.m.b.H
Forchheimergasse 7 Postfach 56
A-1233 Wien(AT)AT**

Patentinhaber: **Vaillant Ltd.
Vaillant House Medway City Estate Trident
Close
Rochester Kent ME2 4EZ(GB)GB**

Patentinhaber: **SCHONEWELLE B.V.
Ellermanstraat 17
NL-1099 BX Amsterdam(NL)NL**

Patentinhaber: **Vaillant GmbH**
**Riedstrasse 8**
**CH-8953 Dietikon 1(CH)CH LI**

(72) Erfinder: **Hangauer, Wilfried, Dr.**
**Heidenstrasse 15**
**W-5609 Hückeswagen(DE)**
Erfinder: **Bark, Dieter**
**Scheidtstrasse 105**
**W-5600 Wuppertal 21(DE)**

(74) Vertreter: **Heim, Johann-Ludwig, Dipl.-Ing.**
**c/o Joh. Vaillant GmbH u. Co Berghauser**
**Strasse 40 Postfach 10 10 20**
**W-5630 Remscheid 1(DE)**

## Beschreibung

Die vorliegende Erfindung bezieht sich auf eine Schaltung zur Abgabe von Zündimpulsen für einen Thyristor oder Triac gemäß dem Oberbegriff des Hauptanspruchs.

Es ist bekannt, sogenannte Vierschichtdioden zur Zündung eines Thyristors oder Triacs einzusetzen, die auch durch ein Ersatzschaltbild dargestellt sein können, das zwei komplementäre Transistoren besitzt, wobei der Kollektor des einen Transistors jeweils mit der Basis des anderen verbunden ist, die beiden Emitter herausgeführte Anschlüsse dieser einen Zweipol bildenden Schaltung darstellen und die beiden Kollektoren über eine Zehnerdiode miteinander verbunden sind. Der Emitter des einen Transistors ist mit einem RC-Glied verbunden, und der des anderen ist über einen Schutzwiderstand mit der Steuerelektrode des Triacs verbunden. Bei einer solchen Schaltung ist die Ansprechschwelle nicht variierbar, und das Kippen dieser Schaltung kann nicht über einen Steuereingang verhindert werden.

Aus M. Kubat: "Power semiconductors", Springer Verlag, 1984, Seiten 435 - 436, ist eine Schaltung zur Abgabe von Zündimpulsen für einen Thyristor bekannt, wobei eine Halbleiter-Zweipolschaltung vorgesehen ist, welche zwei Transistorfunktionen und Kippeigenschaft aufweist und mit der Zündelektrode des Thyristors verbunden ist sowie eingangsseitig mit einem RC-Glied beschaltet ist. Die Schaltung weist einen Transistor auf, dessen Basis mit einer Referenzspannungsquelle und dessen Emitter mit dem RC-Glied verbunden ist. Ein steuerbarer elektronischer Schalter zur Beeinflussung der Zündimpulse ist nicht vorgesehen.

Aus der DE-B-23 30 969 ist eine Schaltungsanordnung zur Erzeugung eines definierten logischen Zustandes, insbesondere zur überwachungssignalgabe in Datenverarbeitungsanlagen bekannt. Diese Schaltung dient nicht zur Abgabe von Zündimpulsen. Folglich ist auch keine Zündelektrode eines Thyristors vorhanden.

In der DE-B-21 11 695 wird eine nach dem Phasenanschnittsprinzip arbeitende Einrichtung zur Abgabe einer Zündspannung für einen Triac beschrieben. In der entsprechenden Schaltung ist eine Steuerspannungsquelle angegeben, wodurch eine Beeinflussung des Zündvorganges nicht möglich ist.

Der vorliegenden Erfindung liegt die Aufgabe zugrunde, die Auslösung der Zündimpulse zu steuern und Fehlzündimpulse zu vermeiden.

Die Lösung dieser Aufgabe gelingt mit den im kennzeichnenden Teil des Hauptanspruchs angegebenen Merkmalen.

Weitere Ausgestaltungen und besonders vorteilhafte Weiterbildungen der Erfindung gehen aus der nachfolgenden Beschreibung hervor, die die Erfindung anhand der Figuren 1 bis 4 der Zeichnung näher erläutert.

Es zeigen:

Figur 1    eine Schaltung in Anwendung auf einen Thyristor,

Figur 2    zeitliche Spannungsverläufe gemäß Figur 1,

Figur 3    eine modifizierte Schaltung in Anwendung auf einen Triac und

Figur 4    eine erfindungsgemäße Ergänzungsschaltung zu Figur 1 beziehungsweise Figur 3.

In den Figuren bedeuten gleiche Bezugszeichen jeweils die gleichen Einzelheiten.

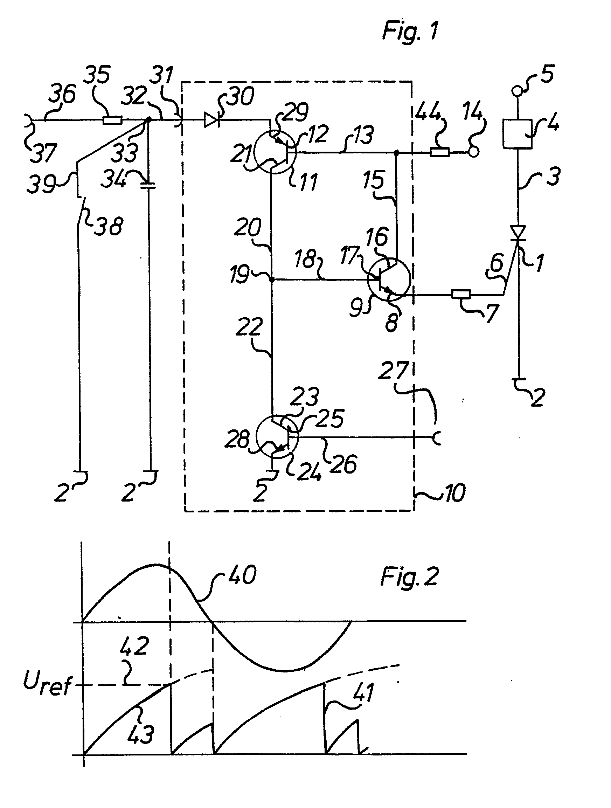

Die Schaltung nach Figur 1 weist einen Thyristor 1 auf, der mit seinem einen Anschluß an Masse 2, mit seinem anderen Anschluß 3 über eine Last 4 mit einer Wechselspannungsquelle 5 verbunden ist. Bei der Last 4 könnte es sich um einen Blankdrahtwiderstand eines elektrischen Durchlauferhitzers handeln. Der Thyristor 1 weist eine Steuerelektrode 6 auf, die über einen Widerstand 7 mit einem Emitter 8 eines NPN-Transistors 9 verbunden ist. Dieser Transistor 9 ist Teil einer Steuerschaltung 10 zur Abgabe der Zündimpulse für den Thyristor 1. Die Steuerschaltung weist einen zweiten Transistor 11 auf, der eine Basis 12 besitzt, die über eine Leitung 13 mit einer Referenzspannungsquelle 14 verbunden ist. Von der Leitung 13 zweigt eine weitere Leitung 15 ab, die mit dem Kollektor 16 des Transistors 9 verbunden ist. Die Basis 17 des Transistors 9 ist über eine Leitung 18 mit einem Verzweigungspunkt 19 verbunden, der einerseits über eine Leitung 20 mit dem Kollektor 21 des Transistors 11 und über eine Leitung 22 parallel hierzu mit einem Kollektor 23 eines dritten Transistors 24 verbunden ist, dessen Basis 25 über eine Leitung 26 mit einem Anschluß 27 verbunden ist. An den Anschluß 27 wird dann eine Spannungsquelle gelegt, wenn ein Zünden des Thyristors 1 verhindert werden soll.

Der Emitter 28 des Transistors 24 liegt an Masse 2.

Der Emitter 29 des Transistors 11 ist über eine in Sperrrichtung geschaltete Diode 30 mit einem weiteren Anschluß 31 der Steuerschaltung verbunden, die über eine Leitung 32 mit einem Verbindungspunkt 33 eines RC-Glieds verbunden ist, dessen einer Zweig aus einem Kondensator 34 und dessen anderer Zweig aus einem Widerstand 35 besteht. Der Widerstand 35 ist mit einer Leitung 36 an einen Anschluß 37 geführt, über den Kondensator 34 ist der Verzweigungspunkt 33 mit Masse 2 verbunden.

Die Funktion der Schaltung nach Figur 1 wird nun anhand der Diagramme der Figur 2 näher erläutert.

In beiden Diagrammen sind Spannungsverläufe in Abhängigkeit von der Zeit beschrieben. Bei der Kurve 40 handelt es sich um die Netzspannung, die beispielsweise am Punkt 5 anliegt, bei der Kurve 41 handelt es sich um den Spannungsverlauf am Verzweigungspunkt 33, vermindert um die Durchlaßspannungen der Diode 30 und der Basis-Emitterdiode des Transistors 11. Die am Punkt 14 anliegende Referenzspannung ist durch den Wert 42 repräsentiert. Dieser Wert ist variabel. An den Punkt 37 wird eine Gleichspannung angelegt, deren Wert variiert werden kann. Der Schalter 38 wird bei jedem Nulldurchgang der Netzspannung 40 kurzzeitig geschlossen. Öffnet demgemäß der Schalter 38, so steigt die Spannung am Kondensator 34 gemäß dem Kurvenzug 43 so lange an, bis die Kondensatorspannung der Referenzspannung 42 entspricht. In diesem Moment werden die bei den Transistoren 11 und 9 leitend, das heißt, über den Widerstand 7 wird ein Zündimpuls an den Thyristor 1 gegeben, da die Schaltung, bestehend aus den beiden Transistoren 9 und 11, kippt, so daß die Spannung zwischen den Emittern 29 und ß auf nahezu Null zusammenbricht. Der Thyristor 1 wird leitend, und die Last wird während der aktuellen Halbwelle der Netzwechselspannung, sofern sie positiv ist, gespeist. Negative Halbwellen werden unterdrückt. Während der negativen Halbwelle findet zwar auch ein Arbeiten der Schaltung 10 statt, nur wirkt sich das auf den Thyristor 1 nicht aus. Das Anlegen einer Spannung am Anschluß 27 bewirkt das Leitendwerden des Transistors 24 und damit ein Sperren des Transistors 9, auch dann, wenn die Ladespannung des Kondensators 34 bereits die Zündspannung erreicht hat. In diesem Fall bleibt der Transistor 11 im aktiven Bereich, so daß die Kondensatorspannung erhalten bleibt, und zwar so lange, bis der Transistor 24 wieder gesperrt wird. Hiermit erfolgt automatisch die Zündung. Ist sie nicht während einer Netzhalbwelle erfolgt, wird der Kondensator anschließend durch Schließen des Schalters 38 wieder entladen. Der Vorteil dieser Schaltung liegt darin, daß unabhängig von der Lage des Zündwinkels stets ein Betreibender Kippschaltung mit demselben. Spannungsniveau erfolgt. Die Höhe der Zündspannung beziehungsweise die Höhe der Zündenergie ist nur abhängig von der Höhe der Referenzspannung an Anschluß 14.

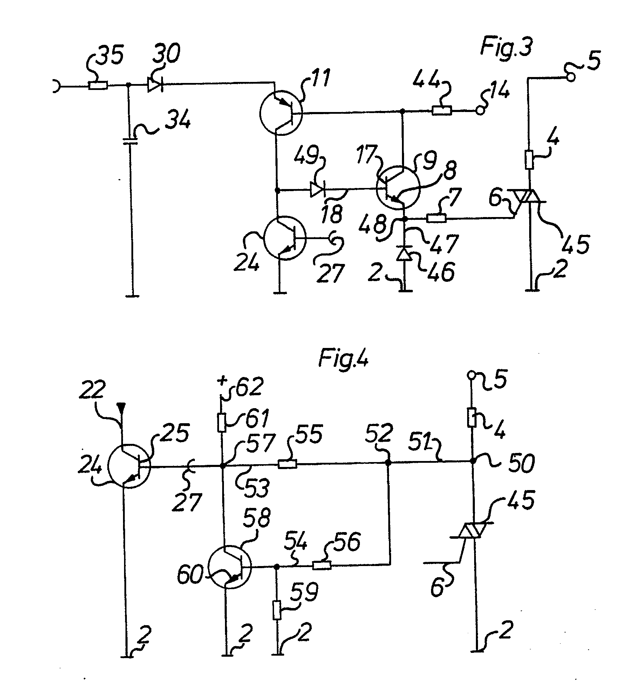

Bei der Figur 3 ist die Schaltung insoweit abgewandelt, daß statt des Thyristors 1 ein Triac 45 verwendet wird. Die Schaltung ist um eine Diode 46 ergänzt worden, die im Zuge einer Leitung 47 von Masse 2 an einen Verbindungspunkt 48 gelegt ist, die einerseits mit dem Emitter 8 des Transistors 9, zum anderen mit dem Widerstand 7 verbunden ist. Weiterhin ist eine Diode 49 vorgesehen, die in die Leitung 18 eingefügt ist. Die Diode 49 ist in Durchlaßrichtung auf die Basis 17, die Diode 46 in Durchlaßrichtung auf den Punkt 48 geschaltet.

Der Vorteil der Schaltung nach Figur 3 liegt darin, daß Netzhalbwellen beider Polarität verarbeitet werden können. Hieraus resultiert aher, daß die Zündelektrode 6 gegenüber Masse 2 negative Werte annehmen kann. Um hier Rückwirkungen auf die Steuerschaltung zu verhindern, sind die beiden Dioden 46 und 49 vorgesehen. Die Diode 46 begrenzt das Auftreten negativer Spannungen am Punkt 48 auf den wert einer Flußspannung. Um auch während negativer Halbwellen den Transistor 9 gesperrt zu halten, wenn der Transistor 24 leitend ist, ist in die Zuleitung 18 zur Basis 17 dieses Transistors die Diode 49 eingeschaltet.

Der Widerstand 44 dient in den Ausführungsbeispielen nach Figur 1 und 3 dazu, den aus der Referenzspannungsquelle 14 fließenden Strom zu begrenzen. Die Diode 30 dient in beiden Schaltungen dazu, ein Laden des Kondensators 34 nur über den Widerstand 35 zu ermöglichen, auch wenn die Spannung der Referenzspannungsquelle 14 höher ist als die zulässige Sperrspannung der Basis-Emitterdiode des Transistors 11.

Die Schaltung nach Figur 4 ist als Ergänzung zur Schaltung nach Figur 3 gedacht.

Zwischen der Last 4 und dem Triac 45 ist ein Verzweigungspunkt 50 vorgesehen, von dem eine Leitung 51 ausgeht, die zu einer zweiten Verzweigungsstelle 52 führt. Von dieser führen zwei Leitungen 53 und 54, die mit je einem Widerstand 55 und 56 versehen sind, zu einem weiteren Verzweigungspunkt 57, wobei die Leitung 53 direkt dorthin, die Leitung 54 hingegen über die Basiskollektorstrecke eines weiteren Transistors 58 dorthin führt. Die Leitung 54 ist im übrigen über einen Widerstand 59 mit Masse 2, der Emitter 60 des Transistors 58 gleichermaßen mit Masse 2 verbunden. Der Punkt 57 ist über einen Widerstand 61 mit positiver Betriebsspannung 62 und mit dem Anschluß 27 verbunden.

Die Schaltung nach Figur 4 dient dazu, unerwünschten Halbwellenbetrieb des Triacs 45 bei induktiver Last 4 und kleinen Zündphasenwinkeln zu vermeiden, beispielsweise dann, wenn die Last 4 ein Asynchronmotor ist und die Gesamtschaltung als Teil einer Drehzahlregelung für diesen Motor dient. Bei einer induktiven Last eilt der Strom der Spannung nach, und es kann vorkommen, daß Zündimpulse zwischen dem Spannungsnulldurchgang und dem nachstfolgenden Stromnulldurchgang erfolgen. Diese Zündimpulse bleiben unwirksam, da der Triac im Stromnulldurchgang ausschaltet und für den Rest der Halbwelle ausgeschaltet bleibt. Die nächste Zündung erfolgt damit erst wieder in der darauffolgenden Halbwelle,,so daß sich Halbwellenbetrieb mit unerwünschter Gleichstrombelastung der Last ergibt.

Ist die Spannung an Punkt 50 auf einem Niveau wesentlich von Null abweichend, gleichgültig ob in positiver oder negativer Richtung, so ist der Transistor 24 gesperrt. Das heißt, eine Zündung des Triacs ist möglich. Liegt der Punkt 50 umgekehrt auf einem Spannungsniveau sehr nahe bei Null, so ist infolge Leitens des Transistors 24 die Abgabe von Zündimpulsen gesperrt. Dies folgt daraus, daß bei Zunahme der Spannung am Punkt 50 in positiver Richtung der Transistor 58 leitend wird, das bedeutet, daß die Spannung im Punkt 57 negativer wird. Damit wird der Transistor 24 gesperrt. Wird die Spannung im Punkt 50 negativ, so wird der Punkt 57 gleichermaßen negativ. Bei Unterschreiten einer Schwellenspannung am Punkt 50, der von den Werten der beiden Widerstände 55 und 61 abhängt, sperrt auch der Transistor 24 wieder. Die Dimensionierung dieser Schaltung hängt also entscheidend von den Werten der Widerstände 55 und 61 einerseits und von denen der Widerstände 56 und 59 andererseits ab. Weiterhin ist maßgeblich die Höhe der positiven Betriebsspannung 62 von Einfluß.

Die in Figur 4 dargestellte Schaltung blockiert das Auftreten von Zündimpulsen während der Einschaltphasen des Triacs und stellt somit sicher daß hei induktiver Last Zündimpulse nicht vor dem Nulldurchgang der vorangegangenen Stromhalbwelle ausgelöst werden. Gleichzeitig wird erreicht, daß nach erfolgter Zündung des Triacs, das heißt mit dem Spannungszusammenbruch am Triac, die aus den Transistoren 9 und 11 bestehende Kippschaltung mit dem Einschalten des Transistors 24 wieder ausgeschaltet wird. Damit wird der Entladevorgang des Kondensators 34 nach erfolgter Zündung abgebrochen, so daß dem Kondensator nur der für die Zündung benötigte Stromimpuls entnommen wird.

## Ansprüche

1.  Schaltung zur Abgabe von Zündimpulsen für einen Thyristor(1) oder Triac(45)mit einer Halbleiter-Zweipolschaltung(9,11), die zwei Transistorfunktionen und Kippeigenschaft aufweist und mit der Zündelektrode des Thyristors (1) beziehungsweise Triacs(45)verbunden ist und die eingangsseitig mit einem RC-Glied-(34,35)beschaltet ist, wobei die Basis(12) des einen Transistors (11)mit einer Referenzspannungsquelle(14),die(17)des anderen(9)mit einem steuerbaren elektronischen Schalter(24)und der Emitter(29) mit der Referenzspannungsquelle(14)verbundenen Transistors(11) mit dem RC-Glied(34,35)-verbunden ist, dadurch gekennzeichnet, daß der Steueranschluß (27) des elektronischen Schalters (24) mit dem Abgriff (57) eines Spannungsteilers (61, 55) verbunden ist, wobei die dem Abgriff abgewandten Anschlüsse der beiden Spannungsteilerwiderstände einerseits mit einem Verbindungspunkt (50) zwischen Triac (45) und der Last (4) und andererseits mit einer Spannungsquelle (62) verbunden sind.

2.  Schaltung nach Anspruch 1, dadurch gekennzeichnet, daß dem einen Widerstand (55) des Spannungsteilers eine Basis-Kollektorstrecke eines weiteren, in Emitterschaltung betriebenen Transistors (58) in Serie mit einem zweiten Spannungsteiler (56, 59) parallelgeschaltet ist.

## Claims

1.  A circuit for delivering firing pulses for a thyristor (1) or triac (45), comprising a semiconductor two-terminal network (9, 11), which has two transistor functions and trigger property and is connected to the starting electrode of the thyristor (1) or triac (45) and is connected at its input to resistance-capacitance means (34, 35), wherein the base (12) of the one transistor (11) is connected to a reference voltage source (14), the base (17) of the other transistor (9) is connected to a controllable electronic switch (24) and the emitter (29) of that transistor (11) which is connected to the reference voltage source (14) is connected to the resistance-capacitance means (34, 35), characterized in that the control terminal (27) of the electronic switch (24) is connected to the tap (57) of a voltage divider (61, 55) and those terminals of the two voltage divider resistors which are remote from the tap are respectively connected to a junction (50) between the triac (45) and the load (4) and to a voltage source (62).

2.  A circuit according to claim 1, characterized in that a base-collector path of a further transistor (58), which is operated in a common emitter circuit, in series with a second voltage divider (56,59) is connected in parallel to the one resistor (55) of the voltage divider.

## Revendications

1.  Montage pour la production d'impulsions pour l'allumage d'un thyristor (1) ou d'un triac (45), soit un montage bipolaire à semi-conducteurs (9,11) avec deux fonctions de transistor et capacité de basculement, relié à l'électrode d'allumage du thyristor (1) ou du triac (45) et dont l'entrée est commandée par un circuit RC (34, 35), la base (12) du transistor (11) étant reliée à une source de tension de référence (14) et la base (17) de l'autre transistor (9), à un organe électronique asservi (24), et l'émetteur (29) du transistor (11) en liaison avec la source de tension de référence (14) étant relié au circuit RC (34, 35), caractérisé par le fait que la borne (27) de l' organe électronique (24) est reliée à la prise (57) d'un diviseur de tension (61, 55), les points de raccordement des deux résistances du diviseur de tension, ne regardant pas la prise (57) étant reliés d'une part à un point de raccordement (50) entre le triac (45) et la charge (4) et, de l'autre, à une source de tension (62).

2. Montage suivant la revendication 1, caractérisé par le fait qu'une jonction collecteur-base d'un autre transistor (58) en montage émetteur et en série avec un deuxième diviseur de tension (56,59) est mise en parallèle avec l'une des résistances (55) du diviseur de division.

*Fig. 1*

*Fig. 2*

Fig.3

Fig.4